# EUROPEAN PATENT APPLICATION

(11) **EP 3 971 777 A1**
(43) Date of publication of application: **23.03.2022**
(21) Application number: 20805924.6
(22) Date of filing: 12.05.2020
(51) Int. Cl.: G06K 19/077, H05K 1/03, H01Q 1/38, H01Q 5/20, B60C 19/00

(54) **PERMANENT ATTACHMENT TYPE UHF BAND RFID TIRE TAG HAVING EXCELLENT BUFFERING PERFORMANCE WITH RESPECT TO EXPANSION AND CONTRACTION MOVEMENT OF TIRE**

(30) Priority: 14.05.2019 KR 20190056359
(71) Applicant: Asiana IDT Inc., Seoul 03161 (KR)
(72) Inventor: YUN, Jong Sup, Incheon 22000 (KR); LEE, Hoonsuk, Incheon 21995 (KR); MOON, Sang Kug, Gimpo-si, Gyeonggi-do 10083 (KR); YOON, Jong Whan, Suwon-si, Gyeonggi-do 16323 (KR)
(74) Representative: Laine IP Oy
(86) International application number: PCT/KR2020/006240
(87) International publication number: WO 2020/231154

(57) **Abstract**

The present invention relates to a permanent attachment type UHF band RFID tire tag having excellent buffering performance with respect to an expansion and contraction movement of a tire and, more specifically, to a permanent attachment type UHF band RFID tire tag having excellent buffering performance with respect to an expansion and contraction movement of a tire, the permanent attachment type UHF band RFID tire tag comprising: an uppermost protective layer; a first adhesive layer adhered to a lower portion of the protective layer; a feeder layer adhered to a lower portion of the first adhesive layer; and a second adhesive layer adhered to a lower portion of the feeder layer. The first adhesive layer is designed to have an area which is greater than the feeder layer and the second adhesive layer, and at the same time, have a size capable of concealing both the feeder layer and the second adhesive layer. In addition, a surface of the second adhesive layer, wherein the surface is opposite to the surface adhered to the feeder layer, and a region of the first adhesive layer other than the region concealing the feeder layer and the second adhesive layer, are attached to the tire.

## Description

### Technical Field

The present disclosure relates to a permanent-attachment-type ultra-high frequency (UHF) band radio frequency identification (RFID) tire tag having excellent buffering performance with respect to expansion and contraction of a tire, wherein a first adhesive layer is designed to have a size that allows the first adhesive layer to conceal both a feeder layer and a second adhesive layer while having a larger area than the feeder layer and the second adhesive layer, and a surface opposite to a surface of the second adhesive layer that is adhered to the feeder layer and a region of the first adhesive layer excluding a region where the first adhesive layer conceals the feeder layer and the second adhesive layer are attached to the tire, thereby having excellent buffering performance with respect to expansion and contraction of the tire.

### Background Art

A technology has been developed that allows company-wide management of tires by embedding radio frequency identification (RFID) tags in tires. This technology refers to a tire-insert-type RFID technology that allows effective management of all logistics information ranging from a production process of tires to sales and disposal thereof by inserting RFID tags, which contain unique information on tires such as a date of manufacture, a manufacturer, and a product number of the tires, into rubber thereof.

However, while a vehicle on which tires are mounted travels, the tires do not maintain their circular shape and instead undergo a curvature change that becomes larger with an increased velocity. In particular, surfaces of the tires that come into contact with the ground become flatter, causing the tires to be deformed to an elliptical shape as a whole, and the tires are restored to their original circular shape when traveling of the vehicle ends and the vehicle reaches a standby state. This is referred to as expansion and contraction of tires.

When a vehicle travels at a high speed, temperature of tires rises to a high temperature of about 200 °C, and the tires undergo intense expansion and contraction according to a sudden change in speed, causing damage to RFID tags due to thermal and mechanical stress exerted on the RFID tags. Therefore, various technologies necessary for reinforcing the durability of the RFID tags embedded in the tires and extending the service life of the RFID tags have been developed.

In relation thereto, Korean Patent Publication No. 10-2013-0110933 discloses "TIRE TO WHICH RFID TAG IS ATTACHED." This related art relates to a position at which an RFID tag, which wirelessly provides various pieces of information on a tire, is attached to the tire. The RFID tag is attached to an inner liner inside the tire. The RFID tag is attached to a surface of the inner liner that ranges from a rim end point to a turn-up portion end point where a space overlaps from the rim end point, at which it is possible to minimize radio frequency interference due to metal materials such as a steel cord, a bead wire, and a rim, which are configured inside the tire, when the tire is mounted on a vehicle, to an apex, at which it is possible to prevent damage to the RFID tag due to expansion and contraction of the tire that occur during traveling of the vehicle, equipment interference upon mounting the tire on the vehicle or detaching the tire therefrom, and the like. According to the RFID tag attachment position of the related art, information on the tire may be maintained in a state in which the RFID tag is attached to the tire from the manufacturing process of the tire to the end of the service life of the tire.

However, the related art is only for determining a position for installing the RFID tag on the inner liner inside the tire that makes it possible to prevent damage to the RFID tag due to expansion and contraction of the tire, equipment interference upon mounting the tire on the vehicle or detaching the tire therefrom, and the like, and there is no further mention of additional ways to protect the RFID tag.

Thus, there is a need to derive a new effective way to protect the RFID tag beyond the related art.

### Technical Problem

The present disclosure is directed to providing a permanent-attachment-type ultra-high frequency (UHF) band radio frequency identification (RFID) tire tag having excellent buffering performance with respect to expansion and contraction of a tire, the permanent-attachment-type UHF band RFID tire tag allowing partial or complete damage to a feeder layer to be prevented despite intense expansion and contraction of the tire during operation of the tire.

The present disclosure is also directed to providing a permanent-attachment-type UHF band RFID tire tag having excellent buffering performance with respect to expansion and contraction of a tire, the permanent-attachment-type UHF band RFID tire tag capable of buffering thermal shock as well as physical shock due to expansion and contraction of the tire, thus allowing a feeder layer substrate to be manufactured using an epoxy-based FR-4 or Teflon material for printed circuit boards (PCBs) that constitutes a PCB and is widely used and inexpensive to manufacture without the need to use a highly heat-resistant and expensive polyimide (PI).

The present disclosure is also directed to providing a permanent-attachment-type UHF band RFID tire tag having excellent buffering performance with respect to expansion and contraction of a tire, the permanent-attachment-type UHF band RFID tire tag capable of protecting a feeder layer with epoxy, thus preventing damage to an antenna pattern or detachment of a device despite expansion and contraction of the tire.

The present disclosure is also directed to providing a permanent-attachment-type UHF band RFID tire tag having excellent buffering performance with respect to expansion and contraction of a tire, in which, in a hierarchical structure constituting the tire tag, an expansion/contraction shock buffering layer having a relatively high rigidity is interposed between the tire and a feeder layer to prevent expansion and contraction of the tire from being propagated to the feeder layer without change, thus ensuring a long service life of the feeder layer and improving the reliability thereof.

### Technical Solution

The present disclosure provides a permanent-attachment-type ultra-high frequency (UHF) band radio frequency identification (RFID) tire tag having excellent buffering performance with respect to expansion and contraction of a tire, the permanent-attachment-type UHF band RFID tire tag including a protective layer disposed at an uppermost portion, a first adhesive layer adhered to a lower portion of the protective layer, a feeder layer adhered to a lower portion of the first adhesive layer, and a second adhesive layer adhered to a lower portion of the feeder layer, wherein the first adhesive layer is designed to have a size that allows the first adhesive layer to conceal both the feeder layer and the second adhesive layer while having a larger area than the feeder layer and the second adhesive layer, and a surface opposite to a surface of the second adhesive layer that is adhered to the feeder layer and a region of the first adhesive layer, excluding a region where the first adhesive layer conceals the feeder layer and the second adhesive layer, are attached to the tire.

A substrate constituting the feeder layer may be configured to include epoxy-based FR-4 or Teflon for printed circuit boards (PCBs).

An expansion/contraction shock buffering layer may be further attached to a lower portion of the second adhesive layer, and a surface opposite to a surface of the expansion/contraction shock buffering layer that is adhered to the second adhesive layer may be attached to the tire.

The expansion/contraction shock buffering layer may have a lower flexibility than the second adhesive layer and thus serve to block expansion and contraction of the tire from being transmitted to the feeder layer.

A third adhesive layer may be attached to a lower portion of the expansion/contraction shock buffering layer, and a surface opposite to a surface of the third adhesive layer that comes into contact with the expansion/contraction shock buffering layer may be directly attached to the tire.

The expansion/contraction shock buffering layer may be a film in bulk.

A substrate constituting the feeder layer may have a thickness that exceeds 0 and is less than or equal to 1.0 mm.

An area of a region of the first adhesive layer excluding a region where the first adhesive layer conceals the feeder layer and the second adhesive layer may be greater than an area of the region where the first adhesive layer conceals the feeder layer and the second adhesive layer.

The feeder layer may be coated with epoxy to prevent detachment of or damage to an antenna pattern and a device, which constitute the feeder layer, despite the expansion and contraction of the tire.

### Advantageous Effects

According to the present disclosure, an effect of preventing partial or complete damage to a feeder layer despite intense expansion and contraction of the tire during operation of the tire is anticipated. This effect is mostly implemented due to the size of a first adhesive layer or a combination of an expansion/contraction shock buffering layer and the size of the first adhesive layer.

Also, according to the present disclosure, since thermal shock as well as physical shock due to expansion and contraction of the tire can be buffered, an effect of allowing a feeder layer substrate to be manufactured using an epoxy-based FR-4 or Teflon material for printed circuit boards (PCBs) that is widely used and inexpensive to manufacture, without the need to use a highly heat-resistant and expensive polyimide (PI), is anticipated.

In particular, according to the present disclosure, despite forming a PCB layer, which is a base material of the feeder layer, to have a large thickness of up to 1.0 mm to more firmly fix an antenna pattern and a device, thus improving the durability of the feeder layer, since PI is not used, there is an advantage of being able to manufacture the feeder layer at a low cost.

Also, according to the present disclosure, by protecting the feeder layer with epoxy, an effect of preventing damage to the antenna pattern or detachment of the device despite the expansion and contraction of the tire is anticipated.

In addition, according to the present disclosure, in a hierarchical structure constituting the tire tag, an expansion/contraction shock buffering layer having a relatively high rigidity is interposed between the tire and the feeder layer. In this way, an effect of preventing the expansion and contraction of the tire from being propagated to the feeder layer without change, thus ensuring a long service life of the feeder layer and improving the reliability thereof, is anticipated.

### Brief Description of Drawings

FIG. 1 is an exploded perspective view illustrating a conventional permanent-attachment-type radio frequency identification (RFID) tag.
FIG. 2 is an exploded perspective view illustrating a permanent-attachment-type RFID tag according to an embodiment of the present disclosure.
FIG. 3 is a cross-sectional view illustrating a state in which the permanent-attachment-type RFID tag according to the embodiment of the present disclosure is attached to a tire.
FIG. 4 is a schematic diagram illustrating a process in which expansion and contraction of the tire, to which the permanent-attachment-type RFID tag according to the embodiment of the present disclosure is attached, is transmitted to a feeder.
FIG. 5 is an exploded perspective view illustrating a permanent-attachment-type RFID tag according to another embodiment of the present disclosure.
FIG. 6 is an exploded perspective view illustrating a permanent-attachment-type RFID tag according to still another embodiment of the present disclosure.

### Modes of the Invention

Hereinafter, specific embodiments for carrying out the present disclosure will be described with reference to the accompanying drawings.

In describing the present disclosure, when it is mentioned that a certain element is connected or linked to another element, although the certain element may be directly connected or linked to the other element, it should be understood that another element may also be present therebetween.

Terms used in the application are merely used to describe specific embodiments and are not intended to limit the present disclosure. A singular expression includes a plural expression unless the context clearly indicates otherwise.

In the application, terms such as "include" or "have" should be understood as specifying that features, number, steps, operations, elements, components, or combinations thereof are present and not as precluding the possibility of the presence or addition of one or more other features, numbers, steps, operations, elements, components, or combinations thereof.

Also, the shape, size, and the like of each element in the drawings may be exaggerated for clear description.

Here, in a permanent-attachment-type ultra-high frequency (UHF) band radio frequency identification (RFID) tire tag 100 of the present disclosure, a first adhesive layer is not attached to an inner surface of a tire, and instead, only a feeder layer part is disposed to be recessed on the inner surface of the tire during vulcanization of the tire that is performed beforehand. Since this is a known art, detailed description thereof will be omitted.

In the present disclosure, expansion and contraction of a tire refer to a series of movement processes of a tire in which the tire maintains its circular shape while a vehicle on which the tire is mounted is in a standby state, the tire is deformed to an elliptical shape while the vehicle travels, and the tire is restored to its original circular shape when the vehicle reaches the standby state again.

That is, the expansion and contraction of the tire is a process in which the tire is deformed from a circular shape to an elliptical shape and then restored to the circular shape. The process in which the tire is deformed and then restored to its original shape is repeated. In this process, stress is exerted on the feeder layer, and as the stress is repeated, damage is caused to the feeder layer. Separation of a protective layer and an adhesive layer due to the expansion and contraction of the tire is another problem.

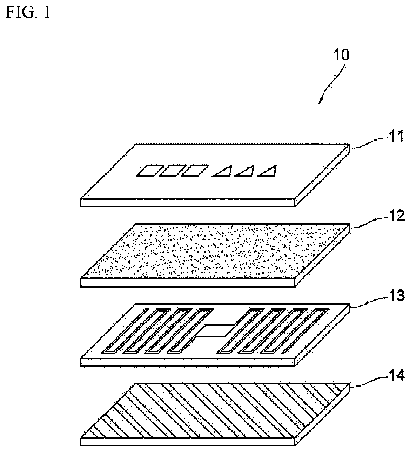

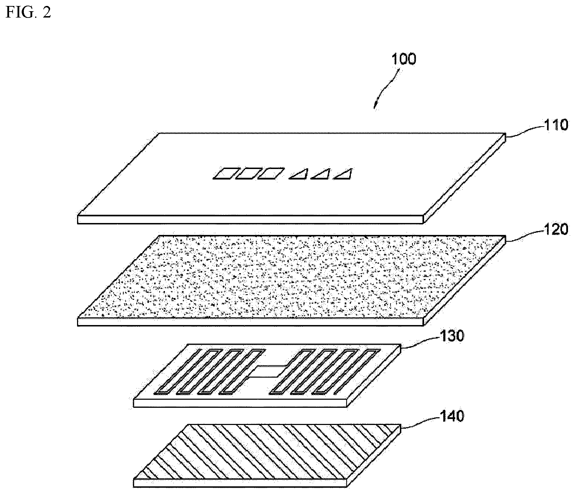

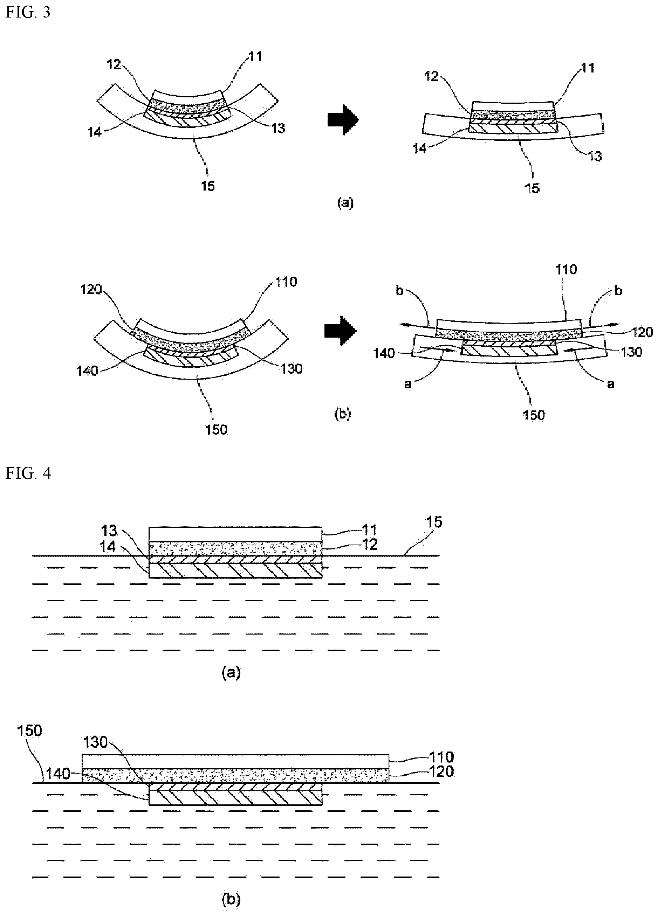

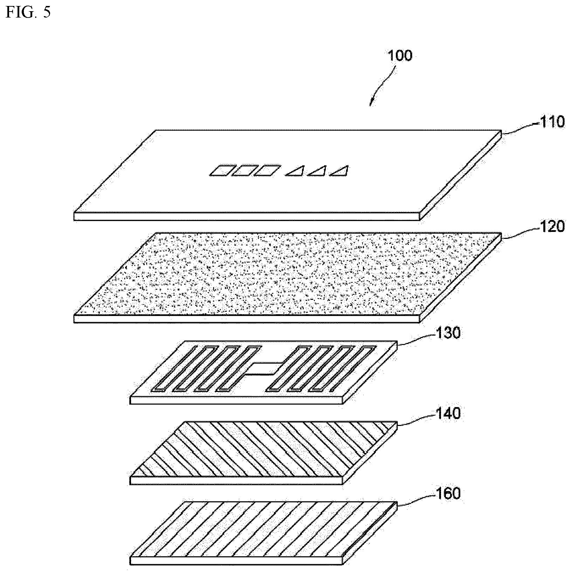

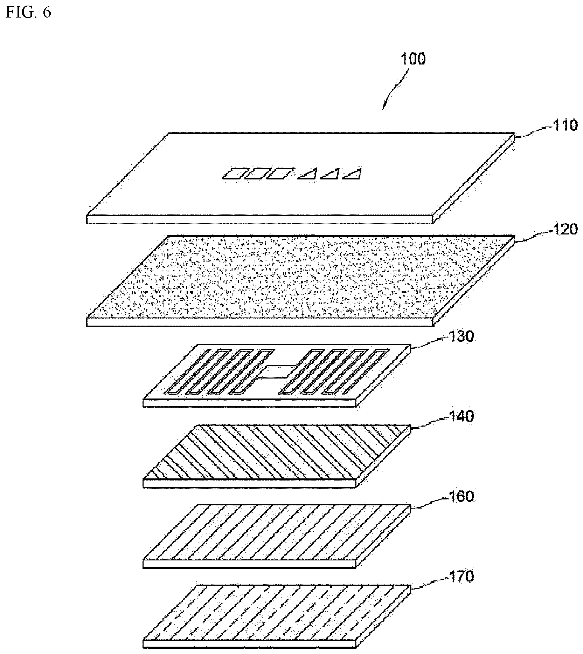

FIG. 1 is an exploded perspective view illustrating a conventional permanent-attachment-type RFID tag, FIG. 2 is an exploded perspective view illustrating a permanent-attachment-type RFID tag according to an embodiment of the present disclosure, FIG. 3 is a cross-sectional view illustrating a state in which the permanent-attachment-type RFID tag according to the embodiment of the present disclosure is attached to a tire, FIG. 4 is a schematic diagram illustrating a process in which expansion and contraction of the tire, to which the permanent-attachment-type RFID tag according to the embodiment of the present disclosure is attached, is transmitted to a feeder, FIG. 5 is an exploded perspective view illustrating a permanent-attachment-type RFID tag according to another embodiment of the present disclosure, and FIG. 6 is an exploded perspective view illustrating a permanent-attachment-type RFID tag according to still another embodiment of the present disclosure.

As illustrated in FIG. 1, a conventional permanent-attachment-type RFID tag 10 includes a protective layer 11, adhesive layers 12 and 14, and a feeder layer 13 which are manufactured to have the same size and shape. Since feeder layers 13 and 130 of attached tags are embedded (disposed to be recessed) by a predetermined degree into an inner surface of a tire during vulcanization of the tire, FIG. 1 has been drawn to reflect this. The same applies for other drawings.

However, since the thickness of the inner surface of the tire has a limit, a feeder layer 130 should not be too thick, and thus, the thickness thereof exceeding 1.0 mm is not desirable.

As illustrated in FIG. 2, the permanent-attachment-type RFID tag according to the embodiment of the present disclosure includes a protective layer 110 disposed at the uppermost portion, a first adhesive layer 120 adhered to a lower portion of the protective layer 110, the feeder layer 130 adhered to a lower portion of the first adhesive layer 120, and a second adhesive layer 140 adhered to a lower portion of the feeder layer 130, wherein the first adhesive layer 120 is designed to have a size that allows the first adhesive layer 120 to conceal both the feeder layer 130 and the second adhesive layer 140 while having a larger area than the feeder layer 130 and the second adhesive layer140. Also, a surface opposite to a surface of the second adhesive layer 140 that is adhered to the feeder layer 130 and a region of the first adhesive layer 120 excluding a region where the first adhesive layer 120 conceals the feeder layer 130 and the second adhesive layer 140 are attached to the tire.

That is, the RFID tag of the present disclosure is different from the conventional RFID tag in that the sizes of the first adhesive layer 120 and the protective layer 110 are configured to be larger than the feeder layer 130, thus causing the entire region of the feeder layer 130 to be embedded by the first adhesive layer 120 and the protective layer 110.

In the RFID tag of the present disclosure, the first adhesive layer 120 is firmly fixed to the inner surface of the tire in addition to covering the feeder layer 130, and due to an effect of fixing the first adhesive layer 120 to an inner surface of a tire 150, as illustrated in FIG. 4, the first adhesive layer 120 and the protective layer 110 have a function of buffering shock related to expansion and contraction of the tire 150 and thus protect the feeder layer 130. While the tire is in a standby state (non-traveling state), the first adhesive layer 120 is fixed to the inner surface of the tire so as to correspond to a curvature of the inner surface of the tire, and while the tire is in a traveling state, from an inner surface of the tire that is involved with a shape change of the tire, particularly, from an interface between the first adhesive layer 120 and the inner surface of the tire, compression stress or tensile stress is applied to the inner surface of the tire. Therefore, in the RFID tag of the present disclosure, since the first adhesive layer 120 serves to buffer shock relating to the expansion and contraction of the tire, such a shock buffering effect also acts on the feeder layer 130 which is coupled to the first adhesive layer 120.

In relation thereto, FIG. 4 illustrates the case in which, from the interface between the first adhesive layer 120 and the inner surface of the tire, compression stress a is applied to the inner surface of the tire, and tensile stress b is applied to the first adhesive layer 120.

On the other hand, in the conventional RFID tag, the effect of fixing the first adhesive layer 120 to the inner surface of the tire is not present. In the conventional RFID tag, it is difficult for the first adhesive layer 120 to perform roles other than fixing the protective layer 110 and protecting the feeder layer 130 from above the feeder layer 130.

In this respect, the RFID tag of the present disclosure is different from the conventional RFID tag.

A substrate constituting the feeder layer 130 may be configured to include epoxy-based FR-4 or Teflon for printed circuit boards (PCBs). FR-4, which is one of the materials of the PCB used in the present disclosure, is formed by stacking glass fibers, which are impregnated with epoxy resin, in multiple layers. FR-4 is a material that is not prone to a dimensional change, has low absorbability, and has frequency characteristics, heat, strength, and the like close to average values as compared to other materials. Performance of FR-4 is excellent relative to price thereof.

As illustrated in FIG. 5, according to another embodiment of the present disclosure, an expansion/contraction shock buffering layer 160 is further attached to a lower portion of the second adhesive layer 140, and a surface opposite to a surface of the expansion/contraction shock buffering layer 160 that is adhered to the second adhesive layer 140 is attached to the tire.

The expansion/contraction shock buffering layer 160 according to the embodiment of the present disclosure has a lower flexibility than the second adhesive layer 140, which is attached to an upper surface of the expansion/contraction shock buffering layer 160, and thus is able to buffer shock relating to the expansion and contraction of the tire. Therefore, the expansion/contraction shock buffering layer 160 serves to block effects of the expansion and contraction of the tire from being transmitted to the feeder layer 130.

As illustrated in FIG. 6, according to still another embodiment of the present disclosure, a third adhesive layer 170 is further attached to a lower portion of the expansion/contraction shock buffering layer 160, and a surface opposite to a surface of the third adhesive layer 170 that comes into contact with the expansion/contraction shock buffering layer 160 is directly attached to the tire. The expansion/contraction shock buffering layer 160 has a lower flexibility than the third adhesive layer 170.

The expansion/contraction shock buffering layer 160 may be a film in bulk. Here, bulk is a term that emphasizes irrelevance to properties of an interface or sufficient apartness from the interface and refers to a material itself or performance of the material. Since the expansion/contraction shock buffering layer 160 is more rigid than the third adhesive layer 170 therebelow or the second adhesive layer 140 thereabove, the expansion/contraction shock buffering layer 160 may, to some extent, prevent excessive contraction and dilation of the second adhesive layer 140 and the third adhesive layer 170 due to the expansion and contraction of the tire.

In the embodiments of FIGS. 5 and 6, the substrate constituting the feeder layer 130 may include epoxy-based FR-4 or Teflon for PCBs or may be made of polyimide (PI). That is, it is fine to use PI.

As described above, the substrate constituting the feeder layer 130 may have a thickness that exceeds 0 and is less than or equal to 1.0 mm. In particular, a thickness of the feeder layer 130 according to the embodiments of FIGS. 5 and 6 may be smaller than a thickness of the feeder layer 130 according to the embodiment of FIG. 2.

An area of a region of the first adhesive layer 120, excluding a region where the first adhesive layer 120 conceals the feeder layer 130 and the second adhesive layer 140, may be greater than an area of the region where the first adhesive layer 120 conceals the feeder layer 130 and the second adhesive layer 140. This is to further strengthen the compression stress or tensile stress applied from the interface between the first adhesive layer 120 and the inner surface of the tire while allowing the first adhesive layer 120 to be more firmly coupled to the inner surface of the tire despite repeated expansion and contraction of the tire.

Meanwhile, although not illustrated, the feeder layer 130 according to the embodiments of the present disclosure may be further coated with epoxy so that, due to a shock buffering action of an epoxy layer, detachment of or damage to an antenna pattern and a device, which constitute the feeder layer 130, is prevented despite the expansion and contraction of the tire.

Performance of the permanent-attachment-type RFID tag according to the embodiments described above was tested together with performance of the conventional permanent-attachment-type RFID tag and compared therewith. This will be described below.

### 1. Tag conditions

Conventional tag (Comparative Example): The first adhesive layer had the same size as the feeder layer and the second adhesive layer, and the expansion/contraction shock buffering layer was not applied.

Tag of the present disclosure (Example 1): The size of the first adhesive layer was larger than the sizes of the feeder layer and the second adhesive layer, and a region of the first adhesive layer excluding a region where the first adhesive layer conceals the feeder layer and the second adhesive layer was firmly attached to the tire. The expansion/contraction shock buffering layer was not applied.

Tag of the present disclosure (Example 2): The size of the first adhesive layer was larger than the sizes of the feeder layer and the second adhesive layer, and a region of the first adhesive layer excluding a region where the first adhesive layer conceals the feeder layer and the second adhesive layer was firmly attached to the tire. The expansion/contraction shock buffering layer was also applied.

In order to effectively check constitutional features of the present disclosure, tires to which the tire tags according to Comparative Example 1 and Examples 1 and 2 are applied were tested. Here, the tires were classified into passenger car tires and bus tires. Tire tests were classified into a durability test and a field test. The durability test was carried out for a short period of time under harsher conditions than actual use conditions assuming that the service life of tires was close to an end. The field test was carried out for a relatively long period of time until tires required replacement after being mounted on actual vehicles.

### 2. Test conditions of passenger car tires

### a. Durability test

In the durability test, conditions under which the service life of tires may be assumed as having reached the end were tested within a short time to assess evaluation of a field test. The durability test was carried out under conditions including a velocity in a range of 200 to 240 km/h, a load in a range of 440 to 830 kg, a pneumatic pressure in a range of 44 to 51 psi, a temperature in a range of 35 to 40 °C, and a running time in a range of 60 to 80 minutes. While the pneumatic pressure in a range of 44 to 51 psi, which is higher than a usual range of pneumatic pressure (in a range of 35 to 38 psi), filled the passenger car tires, a test was carried out by running the tires at a velocity of 200 km/h, which is higher than or equal to twice the normal velocity, for 20 minutes, running the tires at a velocity of 210 km/h for 10 minutes, running the tires at a velocity of 220 km/h for 10 minutes, running the tires at a velocity of 230 km/h for 20 minutes, and then running the tires at a velocity of 240 km/h for 10 minutes. That is, the tires were run at a velocity in a range of 200 km/h to 240 km/h for 70 minutes without a pause. Then, the states of the tire tags were checked.

### b. Travel distance in field test

Meanwhile, in the field test, the tires to which the tire tags were attached were mounted on a private taxi vehicle, and the private taxi vehicle traveled in an actual environment. The private taxi vehicle traveled on paved roads and unpaved roads while switching between high and low velocities. Here, the travel distance was counted every 10,000 km, and the states of the tire tags were checked every 10,000 km.

### 3. Test conditions of bus or truck tires

### a. Durability test

In the durability test, conditions under which the service life of tires may be assumed as having reached the end were tested within a short time to assess evaluation of a field test. The durability test was carried out by running the tires for 56 hours with a velocity of 64 km/h, a pneumatic pressure of 120 psi, and a load being increased from 60% to 180% based on a maximum load of 3,550 kg. (More specifically, based on the load 3,550 kg, the tires were run under 60% load for 8 hours, 85% load for 16 hours, 100% load for 24 hours, 120% load for 2 hours, 140% for 2 hours, 160% for 2 hours, and 180% for 2 hours, thus being run for a total of 56 hours). Then, the states of the tire tags were checked.

### b. Travel distance in field test

Meanwhile, in the field test, the tires to which the tire tags were attached were mounted on a bus or truck vehicle, and the bus or truck vehicle traveled in an actual environment. The bus or truck vehicle traveled on paved roads and unpaved roads while switching between high and low velocities. Here, the travel distance was counted every 10,000 km, and the states of the tire tags were checked every 10,000 km.

### 4. Results

**Table 1**

| | Test of passenger car tires (travel distance) | | | | |
|---|---|---|---|---|---|
| Travel distance (km) | | Example 1 | Example 2 | Comparative Example | Remarks |
| 10,000 | | Good | Good | Good | |
| | 20,000 | Good | Good | Partially defective | |
| | 30,000 | Good | Good | Defective | |
| | 40,000 | Partially defective | Good | - | |
| | 50,000 | Defective | Defective | - | |

**Table 2**

| | Test of bus or truck tires (travel distance) | | | | |
|---|---|---|---|---|---|
| Travel distance (km) | | Example 1 | Example 2 | Comparative Example | Remarks |
| 10,000 | | Good | Good | Good | |
| 20,000 | | Good | Good | Partially defective | |
| 30,000 | | Good | Good | Defective | |
| 40,000 | | Good | Good | - | |
| 50,000 | | Defective | Partially defective | - | |

As can be seen from Tables 1 and 2 above, the conventional tag of FIG. 1 provided as Comparative Example was good in terms of a separation state or signal transmission up to 10,000 km, but as the travel distance exceeded 20,000 km, separation occurred, and a failure occurred in wireless recognition. However, in the case of Examples 1 and 2 of the present disclosure, until at least 30,000 km, tag detachment did not occur, and a wireless recognition state was also good.

**Table 3**

| Travel velocity (km/h) | Example 1 | Example 2 | Comparative Example | Remarks |
|---|---|---|---|---|
| 200 | Good | Good | Good | 20 minutes |
| 210 | Good | Good | Defective | 10 minutes |
| 220 | Good | Good | Defective | 10 minutes |
| 230 | Good | Good | - | 20 minutes |
| 240 | Good | Good | - | 10 minutes |

As can be seen from Table 3 above, in the case of passenger car tires, a defect began to occur at a velocity exceeding 210 km/h in the conventional tag of FIG. 1 provided as Comparative Example. On the other hand, in the case of Examples 1 and 2 of the present disclosure, it was confirmed that, even at a velocity of 240 km/h, a defect did not occur, detachment of the attached tag did not occur, and a wireless recognition state was also good.

**Table 4**

| | Durability test of bus or truck tires (load) | | | | |
|---|---|---|---|---|---|
| Based on load of 3,550 kg | | Example 1 | Example 2 | Comparative Example | Remarks |
| 60% | | Good | Good | Good | 8 hours |
| 85% | | Good | Good | Partially defective | 16 hours |
| 100% | | Good | Good | Defective | 24 hours |
| 120% | | Good | Good | | 2 hours |
| 140% | | Good | Good | | 2 hours |
| 160% | | Good | Good | - | 2 hours |
| 180% | | Good | Good | - | 2 hours |

As can be seen from Table 4 above, in the case of bus or truck tires, a defect began to occur at a load exceeding 85% of the load 3,550 kg in the conventional tag of FIG. 1 provided as Comparative Example. On the other hand, in the case of Examples 1 and 2 of the present disclosure, it was confirmed that, even at a load of 180% of the load 3,550 kg, a defect did not occur, detachment of the attached tag did not occur, and a wireless recognition state was also good.

Note that the examples above are for describing the present disclosure and are not intended to limit the present disclosure. Also, those of ordinary skill in the art of the present disclosure should understand that various embodiments are possible within the scope of the technical spirit of the present disclosure.

## Claims

1. A permanent-attachment-type ultra-high frequency (UHF) band radio frequency identification (RFID) tire tag having excellent buffering performance with respect to expansion and contraction of a tire, the permanent-attachment-type UHF band RFID tire tag comprising:
a protective layer disposed at an uppermost portion;
a first adhesive layer adhered to a lower portion of the protective layer;
a feeder layer adhered to a lower portion of the first adhesive layer; and
a second adhesive layer adhered to a lower portion of the feeder layer,
wherein the first adhesive layer is designed to have a size that allows the first adhesive layer to conceal both the feeder layer and the second adhesive layer while having a larger area than the feeder layer and the second adhesive layer, and
a surface opposite to a surface of the second adhesive layer that is adhered to the feeder layer and a region of the first adhesive layer, excluding a region where the first adhesive layer conceals the feeder layer and the second adhesive layer, are attached to the tire.

2. The permanent-attachment-type UHF band RFID tire tag of claim 1, wherein a substrate constituting the feeder layer is configured to include epoxy-based FR-4 or Teflon for printed circuit boards (PCBs)

3. The permanent-attachment-type UHF band RFID tire tag of claim 1, wherein an expansion/contraction shock buffering layer is further attached to a lower portion of the second adhesive layer, and a surface opposite to a surface of the expansion/contraction shock buffering layer that is adhered to the second adhesive layer is attached to the tire.

4. The permanent-attachment-type UHF band RFID tire tag of claim 3, wherein the expansion/contraction shock buffering layer has a lower flexibility than the second adhesive layer and thus serves to block the expansion and contraction of the tire from being transmitted to the feeder layer.

5. The permanent-attachment-type UHF band RFID tire tag of claim 4, wherein a third adhesive layer is attached to a lower portion of the expansion/contraction shock buffering layer, and a surface opposite to a surface of the third adhesive layer that comes into contact with the expansion/contraction shock buffering layer is directly attached to the tire.

6. The permanent-attachment-type UHF band RFID tire tag of claim 5, wherein the expansion/contraction shock buffering layer is a film in bulk.

7. The permanent-attachment-type UHF band RFID tire tag of claim 1, wherein a substrate constituting the feeder layer has a thickness that exceeds 0 and is less than or equal to 1.0 mm.

8. The permanent-attachment-type UHF band RFID tire tag of claim 1, wherein an area of a region of the first adhesive layer, excluding the region where the first adhesive layer conceals the feeder layer and the second adhesive layer, is greater than an area of the region where the first adhesive layer conceals the feeder layer and the second adhesive layer.

9. The permanent-attachment-type UHF band RFID tire tag of claim 1, wherein the feeder layer is coated with epoxy to prevent detachment of or damage to an antenna pattern and a device, which constitute the feeder layer, despite the expansion and contraction of the tire.
